# EUROPEAN PATENT APPLICATION

(11) **EP 3 142 015 A1**
(43) Date of publication of application: **15.03.2017**
(21) Application number: 16175228.2
(22) Date of filing: 20.06.2016
(51) Int. Cl.: G06F 12/0804, G06F 1/32

(54) **LOW-POWER MEMORY-ACCESS METHOD AND ASSOCIATED APPARATUS**

(30) Priority: 09.09.2015 US 201514848872
(71) Applicant: MediaTek Inc., Hsin-Chu 300 (TW)
(72) Inventor: LEE, Yen-Lin, Zhubei City, Hsinchu County 302 (TW); LI, Yun-Ching, Bade Dist., Taoyuan City 334 (TW); HSIAO, Chih-Hsiang, Neihu Dist., Taipei City 114 (TW); HSIEH, Yu-Cheng, East Dist., Hsinchu City 300 (TW); TU, Li-Chun, East Dist., Hsinchu City 300 (TW)
(74) Representative: 2K Patentanwälte Blasberg Kewitz & Reichel

(57) **Abstract**

A low-power memory access method and associated apparatus are provided. The apparatus includes a memory controller and a processing unit. The memory controller is coupled to a first memory and a second memory, and includes: a memory management circuit, for allocating physical memory addresses of the first memory and the second memory and controlling access of the first memory and the second memory; and a direct-memory-access (DMA) controller. The processing unit is for accessing the first memory and the second memory via the memory controller. When the apparatus is in an active mode, the memory management circuit copies a portion of data stored in the second memory to the first memory for use by the processing unit, and records dirty data information when the portion of data in the first memory differs from that in the second memory.

## Description

### BACKGROUND OF THE INVENTION

### FIELD OF THE INVENTION

The invention relates to memory architecture, and, in particular, to a low-power memory-access method and an associated apparatus capable of using hybrid memory architecture to reduce power consumption in different operation modes.

### DESCRIPTION OF THE RELATED ART

Increasing use of portable computing or electronic devices has led to increased reliance on battery power. Devices such as cell phones, personal digital assistants (PDAs), smartphones, tablet PCs, e-mail devices, audio players, video players, etc., are complex devices often having many functions and subsystems. However, the dynamic random access memory (DRAM) consumes a great portion of the power of the portable device, and the retention power of the DRAM is often a half of the external memory power for daily use. Accordingly, there is high demand for reducing the power consumption of the DRAM as much as possible, thereby increasing the service life of the portable device's battery.

### BRIEF SUMMARY OF THE INVENTION

A detailed description is given in the following embodiments with reference to the accompanying drawings.

An apparatus is provided. The apparatus includes a memory controller and a processing unit. The memory controller is coupled to a first memory and a second memory, and includes: a memory management circuit, for allocating physical memory addresses of the first memory and the second memory and controlling access of the first memory and the second memory; and a direct-memory-access (DMA) controller. The processing unit is for accessing the first memory and the second memory via the memory controller. When the apparatus is in an active mode, the memory management circuit copies a portion of data stored in the second memory to the first memory for use by the processing unit, and records dirty data information when the portion of data in the first memory differs from that in the second memory.

A low-power memory-access method in an apparatus is provided. The apparatus comprises a processing unit and a memory controller, and the apparatus is connected to a first memory and a second memory via the memory controller. The method comprises the steps of: copying a portion of data stored in the second memory to the first memory for use by the processing unit when the apparatus is in an active mode; and recording dirty data information when the portion of data in the first memory differs from that in the second memory.

### BRIEF DESCRIPTION OF THE DRAWINGS

The invention can be more fully understood by reading the subsequent detailed description and examples with references made to the accompanying drawings, wherein:
FIG. 1 is a block diagram of a portable device in accordance with an embodiment of the invention;
FIG. 2A is a diagram of software-transparent memory accessing with hardware assistance in an active mode in accordance with an embodiment of the invention;
FIG. 2B is a diagram of software-transparent memory accessing with hardware assistance in a sleep mode in accordance with an embodiment of the invention;
FIG. 2C is a diagram of software-transparent memory accessing with hardware assistance when waking up the portable device in accordance with an embodiment of the invention;
FIG. 3 is a block diagram of the portable device in accordance with another embodiment of the invention;
FIG. 4 is a diagram of on-demand copying in the software memory management unit in accordance with an embodiment of the invention;
FIGs. 5A~5C are diagrams illustrating power usage of different combinations of the first memory and the second memory in accordance with an embodiment of the invention;
FIG. 6 is an example of calculating power consumption of the hybrid memory architecture in accordance with an embodiment of the invention; and
FIG. 7 is a flow chart of a low-power memory-access method in an apparatus in accordance with an embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

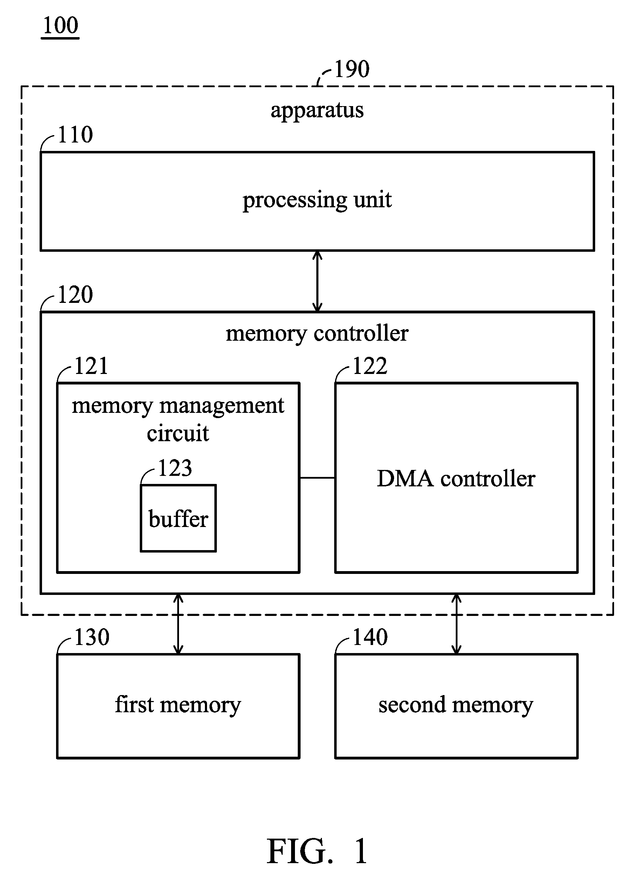

FIG. 1 is a block diagram of a portable device 100 in accordance with an embodiment of the invention. The portable device 100 comprises a processing unit 110, a memory controller 120, a first memory 130, and a second memory 140. The processing unit 110 may access the first memory 120 and the second memory 130 via the memory controller 120. The processing unit 110 comprises one or more processors or other equivalent functional units or circuits. In an embodiment, the processing unit 110 and the memory controller 120 can be integrated into an integrated circuit (IC) or an apparatus 190, e.g. a system-on-chip, and the first memory 130 and the second memory 140 are external to the apparatus 190.

The first memory 130 may be a volatile memory (e.g. low-power DDR SDRAM) which has lower active power but has higher standby power than that of the second memory 140. The second memory 140 may be a non-volatile memory (e.g. magnetoresistive random-access memory (MRAM)) which does not need to refresh or less refresh time to keep data when the power to the second memory 140 is turned off, and the second memory has higher active power than that of the first memory 130. The memory controller 120 comprises a memory management circuit 121, and a direct memory access (DMA) controller 122, where the memory management circuit 121 comprises a buffer 123. The memory management circuit 121 is configured to control data access of both the first memory and the second memory. For example, the buffer 123 may be an SRAM or a register file, but the invention is not limited thereto.

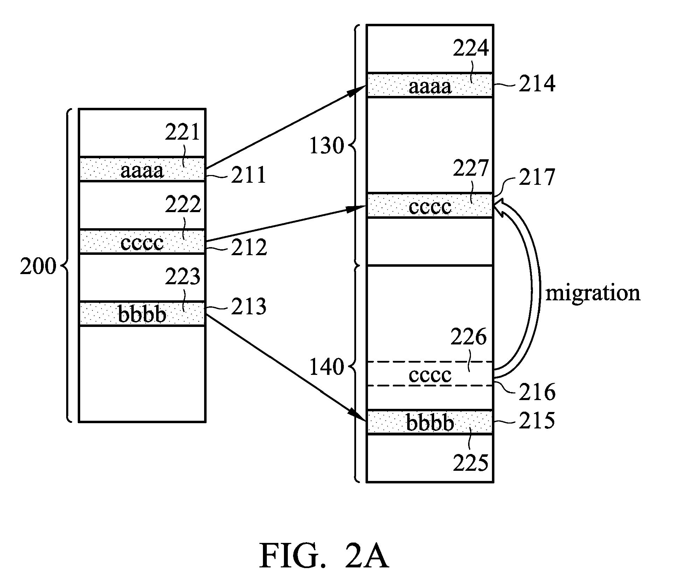

FIG. 2A is a diagram of software-transparent memory accessing with hardware assistance in an active mode in accordance with an embodiment of the invention. The portable device 100 is in an active mode, and the processing unit 110 may access the first memory 130 or the second memory 140 through the memory controller 120. For example, the processing unit 110 may build a software memory map 200 including a plurality of memory addresses (e.g. 211~213) and corresponding data (e.g. 221~213). The processing unit 110 may send a read or write command including a memory address to the memory controller 120, and the memory management circuit 121 of the memory controller 120 may analyze the memory address from the read or write command and determine that the first memory 130 or the second memory 140 is to be accessed. Specifically, the memory management circuit 121 translates the memory address in the software memory map 200 from the processing unit 110 to a physical memory address which may correspond to the first memory 130 or the second memory 140.

Since the active power of the first memory 130 is lower than that of the second memory 140, the frequently or repeatedly used data in the second memory 140 can be "migrated" (i.e. copied) to the first memory 130 to save power when the portable device 130 is in the active mode. In addition, the data in the second memory 140 which is less likely to be used in the active mode will not be migrated to the first memory 130 to reduce the overhead of data copying (i.e. data migration) between the first memory 130 and the second memory 140. For example, the data 211 ("aaaa"), 222 ("bbbb"), and 223 ("cccc") in the memory addresses 211, 212, and 213 of the software memory map 200 are directed to the physical memory address 214 of the first memory 130, the physical memory address 215 of the second memory 140, and the physical memory address 216 of the second memory 140, respectively. Assuming that the data 226 "cccc" stored in the second memory 140 is used frequently or repeatedly, the memory management circuit 121 migrates the data 226 ("cccc") saved in the physical memory address 216 of the second memory 140 to the physical memory address 217 of the first memory 130, and thus the data 227 and 226 are identical at this time. Then, the memory management circuit 121 changes the pointer of the software memory address 212 to direct to the physical memory address 217 of the first memory 130 from the physical memory address 216 of the second memory 140. Accordingly, the memory management circuit 121 may then access the data 227 "cccc" from the physical memory address 217 of the first memory 130 which has lower active power, and thus the power consumption of the portable device 100 can be reduced.

However, during data migration, some data may simultaneously exist in different physical addresses of the first memory 130 and second memory 130. The data stored in the first memory 130 (i.e. destination) may differ from that stored in the second memory 140 (i.e. source) since most of write operations are performed on the first memory 130 to reduce power consumption. When there is data conflict between the first memory 130 and the second memory 140, these data are regarded as "dirty data". The memory management circuit 121 records the dirty data information (i.e. physical memory address, pointer, etc.) of the dirty data between the first memory 130 and the second memory 140 in the buffer 123.

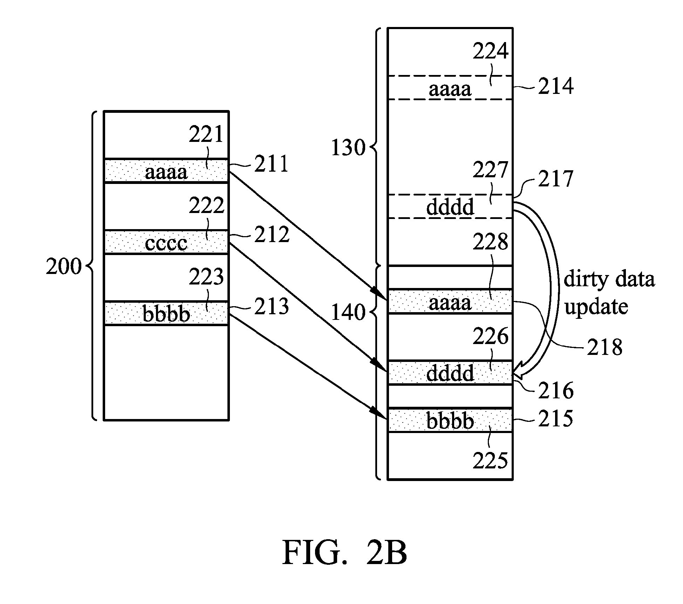

FIG. 2B is a diagram of software-transparent memory accessing with hardware assistance in a sleep mode in accordance with an embodiment of the invention. When the portable device 100 enters a sleep mode, the first memory 130 and the second memory 140 are turned off to save power. Specifically, before the portable device 100 enters a sleep mode, some of the currently used data stored in the first memory 130 should be migrated to the second memory 140 to prevent from data loss.

For example, if the stored data in the first memory 130 are consistent with that in the second memory 140, no migration operation is performed. It should be noted that some pointers in the memory management circuit 121 are directed to the first memory 130 after data migration described in FIG. 2A. For example, the pointers for memory addresses 211 and 212 in the software memory map 200 are directed to the physical memory addresses 214 and 217 of the first memory 130). Thus, the data in the corresponding physical memory address 217 of the first memory 130 may possibly be updated, such as the data 227 being updated to "dddd" which is different from the original data 226 "cccc" corresponding to the physical memory address 216 in the second memory 140. Specifically, if the data stored in a specific physical address of the first memory 130 differs from that in the corresponding physical memory address of the second memory 140 (i.e. dirty data exists), the DMA controller 122 directly accesses and migrates the data stored in the specific physical address of the first memory 130 to the corresponding physical memory address of the second memory 140 according to the dirty data information stored in the buffer 123. For example, the data 226 is updated with the data 227 "dddd" in this case. After the "dirty data" is updated from the first memory 130 to the second memory 140, the first memory 130 and the second memory 140 can be turned off to save power in the sleep mode.

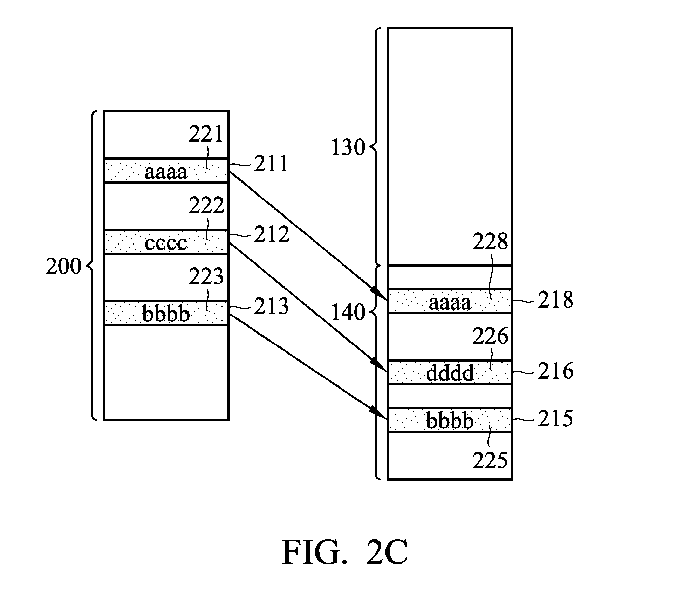

FIG. 2C is a diagram of software-transparent memory accessing with hardware assistance when waking up the portable device in accordance with an embodiment of the invention. In the sleep mode, the first memory 130 and the second memory 140 are both turned off, and the data that was previously used in the active mode is stored in the second memory 140 with "dirty data update". When the portable device 100 is being awakened to the active mode, power to the first memory 130 and the second memory 140 is turned on, and the previously used data stored in the second memory 140 (e.g. data 225, 226 and 228) is directly retrieved by the processing unit 110 via the memory controller 120 to reduce the wake-up time. It should be noted that the first memory 130 is empty and there is no operation on the first memory 130 at this time. After directly retrieving the data stored in the second memory 140, the portable device 100 is awakened to the active mode, and the memory controller 120 may migrate the frequently or repeatedly used data from the second memory 140 to the first memory 130, as described in the embodiment of FIG. 2A.

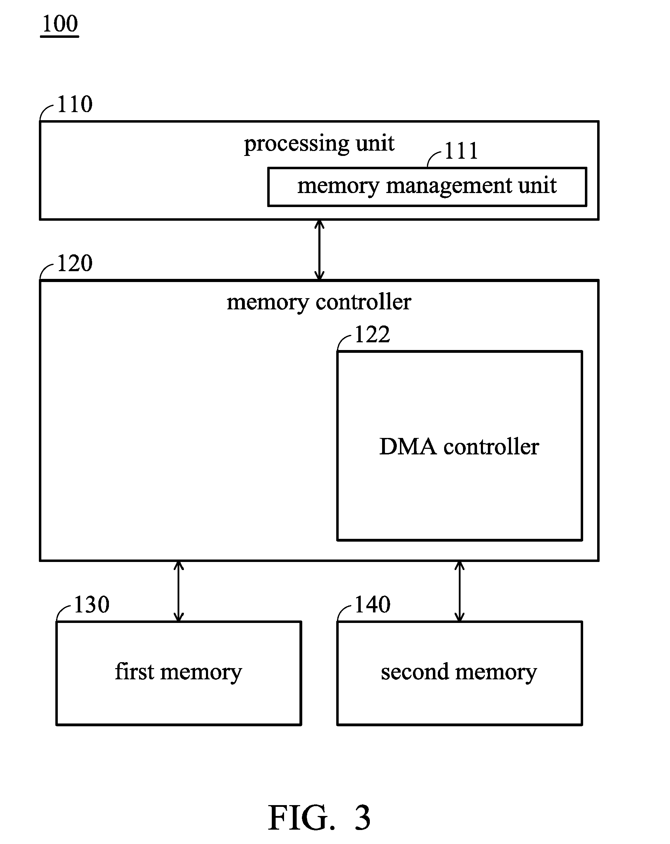

FIG. 3 is a block diagram of the portable device in accordance with another embodiment of the invention. The memory management is performed by a software memory management unit 111 (e.g. a program code or firmware) executed by the processing unit 110. For example, the memory management unit 111 may send different destination memory addresses to the first memory 130 and the second memory 140 to access the data stored in the first memory 130 and the second memory 140.

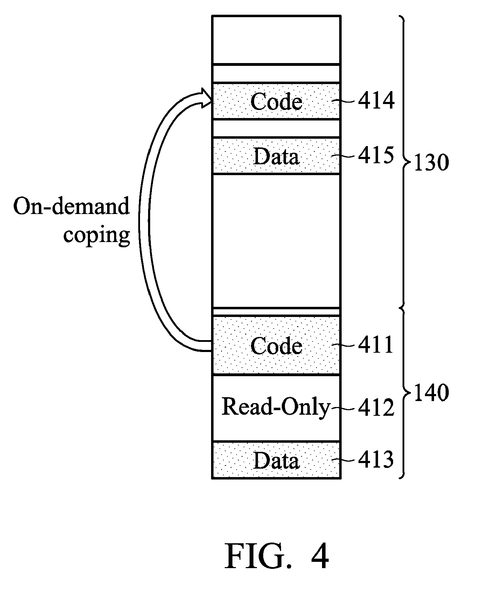

FIG. 4 is a diagram of on-demand copying in the software memory management unit in accordance with an embodiment of the invention. Like the embodiment in FIG. 2A, the memory management unit 111 may copy the frequently or repeatedly used data and program code from the second memory 140 to the first memory 130. For example, the memory management unit 111 copies the program code 411 and data 413 in the second memory 140 to the code 414 and data 415 in the first memory 130 when the portable device 100 is in the active mode.

In addition, the memory management unit 111 also records the "dirty data information" when there is data conflict between the first memory 130 and the second memory 140. When the portable device 100 is entering the sleep mode, the memory management unit 111 determines whether dirty data exists between the first memory 130 and the second memory 140. If dirty data does exist, the memory management unit 111 copies the dirty data in the first memory 130 to the corresponding physical address in the second memory 140 via the DMA controller 122. The details are similar to the embodiment of FIG. 2B. Then, the first memory 130 and the second memory 140 can be turned off after the dirty data has been copied to the second memory 140. If dirty data does not exist, no migration is performed, and the first memory 130 and the second memory 140 can be turned off.

When the portable device 100 is being awakened to the active mode from the sleep mode, the power to the first memory 130 and the second memory 140 is turned on, and the processing unit 111 directly retrieves the required system data stored in the second memory 140. It should be noted that the first memory 130 is empty and there is no operation with the first memory 130 at this time. After directly retrieving the system data stored in the second memory 140, the portable device 100 is awakened to the active mode, and the memory controller 120 may migrate the frequently or repeatedly used data from the second memory 140 to the first memory 130, as described in the embodiment of FIG. 2A.

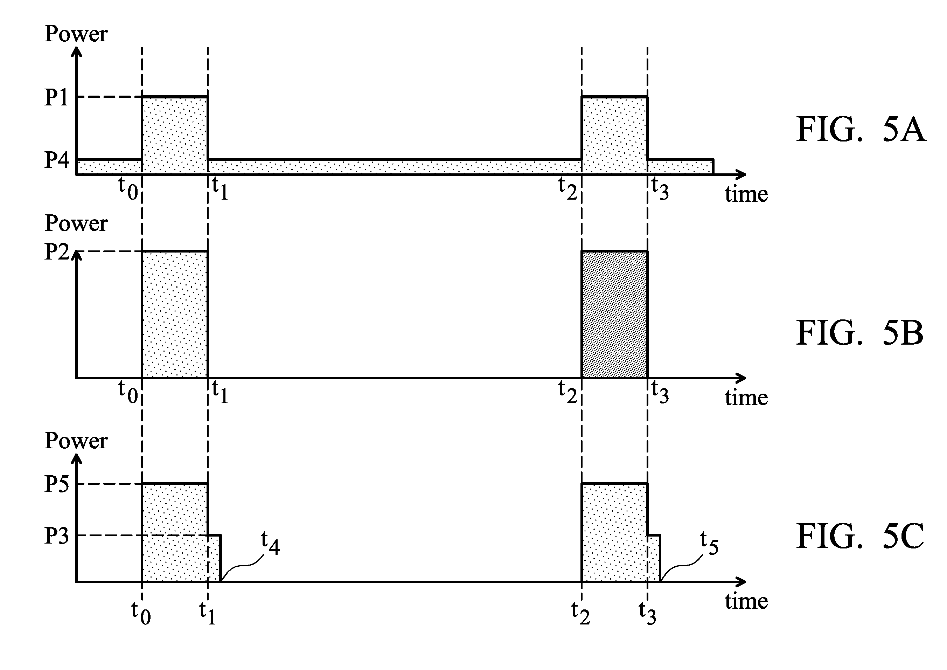

FIGs. 5A~5C are diagrams illustrating power usage of different combinations of the first memory 130 and the second memory 140 in accordance with an embodiment of the invention. The power usage of the first memory 130 is shown in FIG. 5A. During the period between time t0 and t1, the first memory 130 is in the active mode and the active power of the first memory 130 is P1. During the period between time t₁ and t₂, the first memory 130 is in the sleep mode, and the retention power of the first memory 130 is P4, where P1 is larger than P4. The power usage of the second memory 140 is shown in FIG. 5B. During the period between time t₀ and t₁, the second memory 140 is in the active mode, and the active power of the second memory 140 is P2. It should be noted that the active power of the second memory 140 is higher than that of the first memory 130, and thus P2 is greater than P1. During the period between time t₁ and t₂, the second memory 140 is in the sleep mode, and the retention power of the second memory 140 is almost zero.

It should be noted that the portable device 100 uses hybrid memory architecture in the first memory 130 and the second memory 140, and the hybrid memory architecture has the advantages of the first memory 130 and the second memory 140 being in the active mode and the sleep mode, respectively. Specifically, the power usage of the hybrid memory architecture is shown in FIG. 5C. During the period between time t₀ and t₁, the hybrid memory architecture is in the active mode, and the frequently or repeatedly used data has been copied to the first memory 130 which has lower active power. Thus, the active power P5 of the hybrid memory architecture is slightly higher than the active power P1 of the first memory 130. When the portable device begins to enter the sleep mode at time t₁, the memory management circuit 121 (or the memory management unit 111) copies the dirty data, that has data conflict between the first memory 130 and the second memory 140, from the first memory 130 to the second memory 140 according to the dirty data information stored in the buffer 123 via the DMA controller 122. Specifically, during the period between time t₁ and t₄, the dirty data in the first memory 130 is backed up in the second memory 140, and the active power of the hybrid memory architecture is P3. Thus, the first memory 130 and the second memory 140 can be turned off at time t₄, and the retention power of the hybrid memory architecture is approximately zero, like that of the second memory 140.

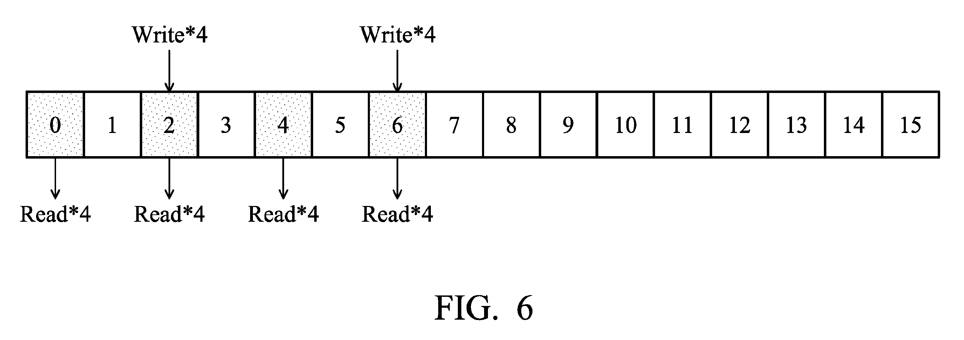

FIG. 6 is an example of calculating power consumption of the hybrid memory architecture in accordance with an embodiment of the invention. In one scenario, the power consumption for a read command and a write command of the first memory 130 is 1 power unit, and the power consumption for a read command and a write command of the second memory 140 is 1.5 power units. Each of the first memory 130 and the second memory 140 has 16 blocks (e.g. block 0~15), where 64 bits of data can be stored in each block. It is assumed that four read operations are performed on blocks 0, 2, 4, and 6, and four write operations are performed on blocks 2 and 6. If prior suspend-to-storage technology and recovery-from-storage technologies are used in the portable device 100, there are 4x4 active read operations and 2x4 active write operations on the first memory 130. When the portable device 100 is entering the sleep mode, all the data in each block of the first memory 130 are backed up to the second memory 140, and thus there are 16 read operations performed on the first memory 130 and 16 write operations performed on the second memory 140. In addition, when the portable device 100 is being awakened to the active mode, the DMA controller 122 first retrieves all the data stored in the second memory 140 and then writes the retrieved data into the first memory 130, thereby awakening the portable device 100 to the active mode. In other words, the processing unit 110 always reads the required data from the first memory 130 if prior techniques are used. Accordingly, the estimated power for the prior technologies in the scenario is 16x1 + 16*1.5 power units for system recovery, 16x1 + 8x1 power units for the active mode, and 16x1 + 16x1.5 power units for backing up data, and the total power is 104 power units.

Furthermore, the hybrid memory architecture is used in the portable device 100, and it is assumed that the operating system of the portable device 100 can be recovered using the data in the blocks 0, 2, 4, and 6. When the data in each of blocks 0, 2, 4, and 6 are read four times in the scenario, the data in blocks 0, 2, 4, and 6 can be read from the second memory 140 once, and this data can be written into blocks 0, 2, 4, and 6 in the first memory for later use. Thus, the remaining three read operations on blocks 0, 2, 4, and 6, and four write operations on blocks 2 and 6 can be performed on the first memory 130 to save power. It should be noted that the data in blocks 2 and 6 are regarded as "dirty data" between the first memory 130 and the second memory 140 since four write operations are performed on blocks 2 and 6 in the first memory 130. However, data in other blocks besides blocks 2 and 6 in the second memory 140 remain unchanged. When the portable device 100 is entering the sleep mode, the data in blocks 2 and 6 of the first memory 130 are updated to the blocks 2 and 6 of the second memory 140, and thus there are two read operations on the first memory 130 and two write operations on the second memory 140 for backing up data. Accordingly, the estimated power for the hybrid memory architecture in the scenario is 4x1 for system recovery, 12x1 + 8x1 + 4x1.5 for the active mode, and 2x1 + 2x1.5 for data backup, and the total power is 35 power units.

It should be noted that the power unit in the aforementioned embodiment indicates power consumption, and can be measured in Watts, but the invention is not limited thereto. It should also be noted that the numeric values for the power consumption of the first memory 130 and the second memory 140 are for ease of description, and the invention is not limited thereto.

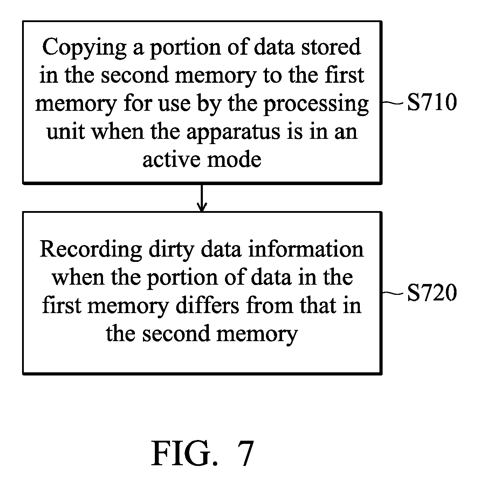

FIG. 7 is a flow chart of a low-power memory-access method in an apparatus in accordance with an embodiment of the invention. Referring to FIG. 1 and FIG. 7, in step S710, a portion of data stored in the second memory 140 is copied to the first memory 130 for use by the processing unit 110 when the apparatus is in an active mode. In step S720, dirty data information is recorded by the memory management circuit 121 when the portion of data in the first memory differs from that in the second memory. It should be noted that the recorded dirty data information is used to copy the dirty data from the first memory 130 to the second memory 140 when the apparatus 190 is entering the sleep mode. Thus, the number of memory access operations on the first memory 130 and the second memory 140 can be reduced. Furthermore, the processing unit 110 retrieves system data directly from the second memory 140 when the apparatus 190 is being awakened to the active mode from the sleep mode, thereby achieving fast waking-up of the apparatus 190.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An apparatus, comprising:
a memory controller, coupled to a first memory and a second memory,
wherein the memory controller comprises:
a memory management circuit, for controlling access of the first memory and the second memory; and
a direct-memory-access (DMA) controller; and
a processing unit, for accessing the first memory and the second memory via the memory controller,
wherein when the apparatus is in an active mode, the memory management circuit copies a portion of data stored in the second memory to the first memory for use by the processing unit, and records dirty data information when the portion of data in the first memory differs from that in the second memory.

2. The apparatus as claimed in claim 1, wherein the first memory is a volatile memory and the second memory is a non-volatile memory.

3. The apparatus as claimed in claim 1, wherein active power of the first memory is lower than that of the second memory, and standby power of the first memory is higher than that of the second memory.

4. The apparatus as claimed in claim 1, wherein the copied portion of data is used frequently by the processing unit.

5. The apparatus as claimed in claim 1, wherein when the apparatus is entering a sleep mode, the memory management circuit copies dirty data from the first memory to the second memory according to the recorded dirty data information, wherein the memory controller turns off the first memory and the second memory after the dirty data has been copied from the first memory to the second memory.

6. The apparatus as claimed in claim 5, wherein when the apparatus is being awakened to the active mode, the memory controller turns on the first memory and the second memory, and the processing unit directly retrieves system data from the second memory via the DMA controller.

7. The apparatus as claimed in claim 5, wherein the memory management circuit translates a software memory address from the processing unit into a first physical memory address in the first memory or a second physical memory address in the second memory.

8. The apparatus as claimed in claim 7, wherein when the memory management circuit copies the portion of data from the second memory to the first memory, the memory management circuit changes a pointer of the software memory address to direct to the first memory from the second memory.

9. The apparatus as claimed in claim 8, wherein when the memory management circuit copies dirty data from the first memory to the second memory according to the dirty data information, the memory management circuit changes the pointer of the software memory address to direct to the second memory from the first memory.

10. A low-power memory-access method in an apparatus, wherein the apparatus comprises a processing unit and a memory controller, and the apparatus is connected to a first memory and a second memory via the memory controller, the method comprising:
copying a portion of data stored in the second memory to the first memory for use by the processing unit when the apparatus is in an active mode; and
recording dirty data information when the portion of data in the first memory differs from that in the second memory.

11. The method as claimed in claim 10, wherein the first memory is a volatile memory and the second memory is a non-volatile memory.

12. The method as claimed in claim 10, wherein active power of the first memory is lower than that of the second memory, and standby power of the first memory is higher than that of the second memory.

13. An apparatus, comprising:
a memory controller, coupled to a first memory and a second memory,
wherein the memory controller comprises:
a direct-memory-access (DMA) controller; and
a processing unit, for accessing the first memory and the second memory via the memory controller, and allocating physical memory addresses of the first memory and the second memory,
wherein when the apparatus is in an active mode, the processing unit copies a portion of data stored in the second memory to the first memory for use by the processing unit, and records dirty data information when the portion of data in the first memory differs from that in the second memory.

14. The apparatus as claimed in claim 13, wherein active power of the first memory is lower than that of the second memory, and standby power of the first memory is higher than that of the second memory.

15. The apparatus as claimed in claim 13, wherein the copied portion of data is used frequently or repeatedly by the processing unit.
